# EUROPÄISCHE PATENTSCHRIFT

(11) **EP 3 379 554 B1**
(45) Veröffentlichungstag und Bekanntmachung des Hinweises auf die Patenterteilung: **16.10.2019**
(21) Anmeldenummer: 17162143.6
(22) Anmeldetag: 21.03.2017
(51) Int. Cl.: H01H 13/02, H01H 13/705, H01H 9/02, H03K 17/96, H01H 13/7057

(54) **TASTENMODUL FÜR MODULARE SYSTEMGERÄTE DER GEBÄUDEELEKTROINSTALLATION UND HAUSTÜRKOMMUNIKATION**
KEY MODULE FOR MODULAR BUILDING ELECTRONICS SYSTEM DEVICES AND HOUSE DOOR COMMUNICATION
MODULE-CLÉ POUR APPAREILS DE SYSTÈME MODULAIRE DE L'INSTALLATION ÉLECTRIQUE DE BÂTIMENT ET COMMUNICATION DE PORTE D'ENTRÉE

(43) Veröffentlichungstag der Anmeldung: 26.09.2018
(73) Patentinhaber: GIRA GIERSIEPEN GmbH & Co. KG, 42477 Radevormwald (DE)
(72) Erfinder: SCHWARZER, Carsten, 42499 Hückeswagen (DE); HEINBACH, Christoph, 57250 Netphen (DE)
(74) Vertreter: Patent- und Rechtsanwälte Dr. Solf & Zapf

(56) Entgegenhaltungen:
- DE-A1-102004 004 247
- DE-A1-102011 079 902
- DE-U1- 20 010 996

## Beschreibung

Die Erfindung betrifft ein Tastenmodul für modulare Systemgeräte der Gebäudeelektroinstallation oder Haustürkommunikation, aufweisend mindestens eine durch Druck in eine Druckrichtung senkrecht zu einer Grundrissebene betätigbare Taste, und ein in Druckrichtung in einen Systemträger eines Systemgerätes montierbares Modulunterteil, und ein durch Montage in der Druckrichtung mit dem Modulunterteil verbundenes Moduloberteil, wobei das Moduloberteil einen Tastenträger umfasst, an dem die Taste in Druckrichtung beweglich gelagert angeordnet ist, und wobei in dem Modulunterteil ein Schaltungsträger mit einer elektronischen Schaltung aufgenommen ist, welche Schaltsensoren enthält, mittels derer unter der Wirkung des in der Druckrichtung auf die Taste ausgeübten Druckes ein Schaltvorgang ausgelöst wird.

Derartige Tastenmodule sind insbesondere aus der EP 2 645 392 A1 bekannt. Bei diesem Tastenmodul sind die Schaltsensoren als piezoelektrische Elemente ausgebildet, die über pro Schaltsensor separate Druckübertragungselemente betätigt werden. Die Herstellung derartiger Tastenmodule ist relativ aufwändig. Zudem wirkt sich die beschriebene Lösung nachteilig auf eine Erzeugung einer vollflächigen homogenen Tastenbetätigung aus. Dies ist insbesondere bezogen auf die Anfordernisse bezüglich AAL (Ambient Assisted Living) für ältere oder behinderte Personen problematisch, da bei diesen Anwendungen relativ große Tastenflächen verwendet werden und die Taste möglichst an jeder Stelle mit einer gleichen Druckkraft betätigbar sein sollte Ein weiteres Beispiel eines Tastenmodules ist aus der DE-A-102011079902 bekannt.

Der Erfindung liegt die Aufgabe zugrunde, ein Tastenmodul zur Verfügung zu stellen, welches eine möglichst vollflächig homogene Tastenbetätigung auf einfache Weise bei relativ großen Tastenflächen ermöglicht.

Die Aufgabe wird erfindungsgemäß durch die Merkmale des kennzeichnenden Teils des Anspruchs 1 gelöst. Erfindungsgemäß sind die Schaltsensoren des Schaltungsträgers als MOC-Tastfeld ausgebildet, und ist in einer Aufnahmeöffnung des Tastenträgers mindestens ein Druckübertragungselement pro Taste zur Betätigung des MOC-Tastfeldes in Druckrichtung über mindestens ein MOC-Tastfeld bewegbar gelagert angeordnet, und ist die Taste mit dem Druckübertragungselement verbunden. Vorzugsweise ist das Druckübertragungselement in Druckrichtung unmittelbar anliegend an das MOC-Tastfeld oder die MOC-Tastfelder angeordnet und insbesondere die Taste in Druckrichtung ist unmittelbar anliegend an das Druckübertragungselement angeordnet. Die Verwendung von MOC-Tastfeldern ermöglicht eine kostengünstige Herstellung der Schaltsensoren. Zudem ist die geringe Bauhöhe der Schaltsensoren vorteilhaft. Die MOC-Tastfelder können auf einfache Weise als relativ großflächige Schaltsensoren ausgebildet werden, was eine homogene vollflächige Bestätigung verbessert. Die Anordnung der Druckübertragungselemente unmittelbar anliegend an den MOC-Tastfeldern und der Tasten unmittelbar anliegend an den Druckübertragungselementen ermöglicht eine niedrige Bauhöhe und eine verbesserte direkte Übertragung der Betätigungskraft. Dies erleichtert die Einstellung eines zulässigen Bereiches für die Betätigungskraft.

Vorzugsweise ist das Druckübertragungselement in Druckrichtung über mindestens zwei in einer Längsrichtung der Taste nebeneinander angeordneten MOC-Tastfeldern angeordnet. Dies ermöglicht eine Vergrößerung der Tasten in Längsrichtung und damit eine einfachere Betätigung der Tasten.

In einer bevorzugten Ausführungsform ist eine Weichkomponente aus einem elastischen Material stoffschlüssig mit dem Druckübertragungselement und dem Tastenträger verbunden und das Druckübertragungselement mittels der Weichkomponente in der Aufnahmeöffnung des Tastenträgers schwimmend gelagert. Insbesondere ist die Weichkomponente als eine die Druckübertragungselemente vollständig umlaufende und in einem durch die Aufnahmeöffnung gebildeten Spalt zwischen Druckübertragungselement und Tastenträger angeordnete Dichtung ausgebildet. Weiterhin vorteilhaft ist, wenn die Weichkomponente auf der dem Bedienelement zugewandten Seite des Druckübertragungselementes eine im Randbereich des Druckübertragungselementes angeordnete umlaufende Dichtlippe bildet. Vorzugsweise sind das Druckübertragungselement, die Weichkomponente und der Tastenträger als Drei-Komponenten-Teil einteilig ausgebildet. Dies ermöglicht eine besonders einfache und Bauraum einsparende Lagerung des Druckübertragungselementes, wobei die Weichkomponente gleichzeitig als Abdichtung des Tastenmoduls gegen Feuchtigkeit und Verschmutzung des Inneren des Tastenmoduls dient.

Vorteilhafterweise ist die Weichkomponente auch zwischen Taste und Tastenträger angeordnet, wobei die Taste mittels Befestigungsmitteln und einem Begrenzungselement an der der Taste abgewandten Seite des Tastenträgers mit einer Vorspannung auf die Weichkomponente in Richtung des Tastenträgers gezogen wird. Insbesondere ist die Taste durch Anlage auf der Weichkomponente an der der Taste zugewandten Seite des Tastenträgers und gleichzeitige Anlage des Begrenzungselementes an der der Taste abgewandten Seite des Tastenträgers spielfrei gelagert. Dies ermöglicht eine Abdichtung der Tasten und ermöglicht eine besonders einfache Einstellung der erforderlichen Betätigungskraft für die Taste.

In einer weiterführenden Ausgestaltung weist der Schaltungsträger mindestens eine LED auf, die derart unter dem Moduloberteil angeordnet ist, dass ihr Licht in das Druckübertragungselement eingeleitet wird und dieses beleuchtet. Insbesondere weist der Tastenträger und/oder das Druckübertragungselement auf der der LED zugewandten Seite Einstrahlöffnungen auf, in die die LED hineinragt und/oder einstrahlt. Vorteilhafterweise ist das Druckübertragungselement aus einem lichtdurchlässigen und/oder lichtleitenden Material ausgebildet. Dies ermöglicht eine besonders flache Bauweise und eine einfache und möglichst gleichmäßige Hintergrundbeleuchtung des Beschriftungsfeldes.

Weiterhin hat sich als besonders vorteilhaft herausgestellt, wenn pro Taste genau zwei MOC-Tastfelder bezogen auf eine Mittelsenkrechte der Taste spiegelsymmetrisch zueinander und in Längsrichtung der Taste voneinander beabstandet angeordnet sind. Dabei beträgt der Abstand eines Mittelpunktes (M) der beiden MOC-Tastfelder von der Mittelsenkrechten insbesondere mindestens 0,5 X und höchstens 0,75 X, wobei X die halbe Länge der Taste in Längsrichtung ist.

Weitere vorteilhafte Ausgestaltungen der Erfindung ergeben sich aus der folgenden Figurenbeschreibung und den abhängigen Unteransprüchen.

Es zeigen:
- Fig. 1: eine dreidimensionale Ansicht eines erfindungsgemäßen Tastenmoduls,
- Fig. 2: eine dreidimensionale Explosionszeichnung eines erfindungsgemäßen Tastenmoduls,
- Fig. 3: einen Teilschnitt durch das zusammengesetzte Tastenmodul,
- Fig. 4: eine Vergrößerung eines Ausschnitts der Fig. 3 im Bereich einer Taste,
- Fig. 5: eine dreidimensionale Ansicht des Schaltungsträgers als Explosionszeichnung einer Hälfte der Vorderseite des Schaltungsträgers, und
- Fig. 6: eine schematische Ansicht einer erfindungsgemäßen Anordnung der MOC-Tastfelder bezogen auf eine Taste.

In den verschiedenen Figuren der Zeichnung sind gleiche Teile stets mit denselben Bezugszeichen versehen.

Zu der anschließenden Beschreibung wird beansprucht, dass die Erfindung nicht auf die Ausführungsbeispiele und dabei nicht auf alle oder mehrere Merkmale von beschriebenen Merkmalskombinationen beschränkt ist, vielmehr ist jedes einzelne Teilmerkmal des/jedes Ausführungsbeispiels auch losgelöst von allen anderen im Zusammenhang damit beschriebenen Teilmerkmalen für sich und auch in Kombination mit beliebigen Merkmalen eines anderen Ausführungsbeispiels von Bedeutung für den Gegenstand der Erfindung.

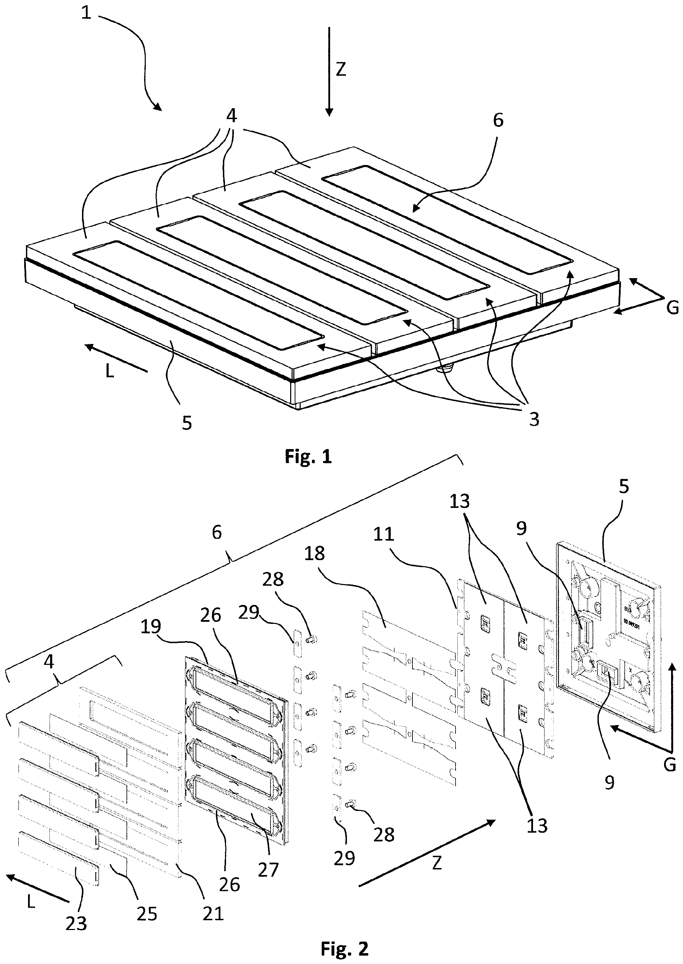

Figur 1 zeigt eine dreidimensionale Ansicht eines erfindungsgemäßen Tastenmoduls 1. Das Tastenmodul 1 ist Teil eines nicht dargestellten modularen Systemgerätes der Gebäudeelektroinstallation oder Haustürkommunikation und stellt als eins von mehreren Systemmodulen frontseitige Tasten 3 des Systemgerätes, zum Beispiel der Türstation oder der Wohnungsstation, zur Verfügung. Das Tastenmodul 1 weist mindestens eine Taste 3 und vorteilhafterweise zwei, drei oder vier Tasten 3 auf. Das Tastenmodul 1 ist in Druckrichtung Z der Tasten 3 betrachtet insbesondere quadratisch ausgebildet. Die Tasten 3 weisen jeweils insbesondere rechteckige Betätigungselemente 4 auf. Die Betätigungselemente 4 erstrecken sich vorzugsweise in ihrer Längsrichtung von Rand zu Rand über die gesamte Breite des Tastenmoduls 1, so dass die Tasten 3 ohne zusätzlichen Rahmen auf dem Tastenmodul 1 angeordnet sind. Die Betätigungselemente 4 weisen vorzugsweise in ihrer Querrichtung eine Höhe von einem Viertel der Höhe des Tastenmoduls 1 auf.

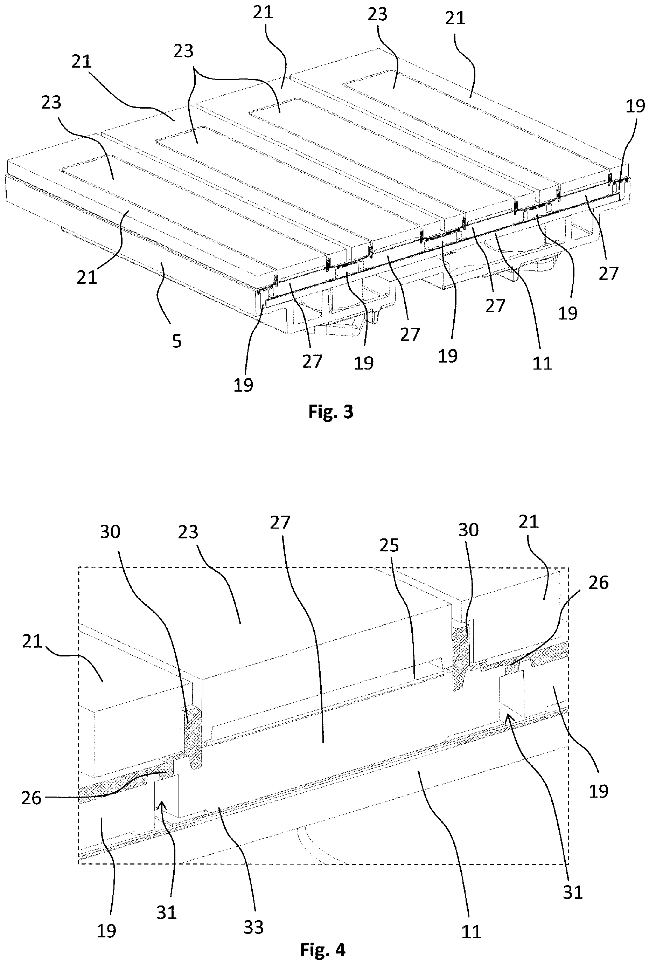

Figur 2 zeigt eine dreidimensionale Explosionszeichnung eines erfindungsgemäßen Tastenmoduls 1, und Figur 3 zeigt einen Teilschnitt durch das zusammengesetzte Tastenmodul 1, und Figur 4 zeigt eine Vergrößerung eines Ausschnitts der Figur 3 im Bereich einer Taste 3. Das Tastenmodul 1 weist ein Modulunterteil 5 und ein Moduloberteil 6 auf. Das Modulunterteil 5 weist an seiner Außenseite insbesondere Befestigungsmittel zur Montage an einem nicht dargestellten Systemträger auf. Der Systemträger dient zur Aufnahme und Verbindung mehrerer Systemmodule zur modularen Zusammenstellung des Systemgerätes und zur Montage des Systemgerätes an einer Wand oder in einem Gehäuse des Systemgerätes.

In dem Modulunterteil 5 ist mindestens eine Durchgangsöffnung 9 in der rückwärtigen Gehäusewandung angeordnet. In dem dargestellten Ausführungsbeispiel weist das Modulunterteil 5 zwei gleich große und mit gleicher Umfangskontur ausgebildete Durchgangsöffnungen 9 auf, die um 90° zueinander verdreht in der Gehäusewandung angeordnet sind. Das Modulunterteil 5 bildet eine Aufnahmeöffnung, in der ein Schaltungsträger 11 angeordnet ist. Der Schaltungsträger 11 weist an seiner dem Modulunterteil 5 zugewandten Rückseite mindestens einen elektrischen Steckkontakt auf. Der Steckkontakt ist mit der Durchgangsöffnung 9 fluchtend angeordnet, wobei die Steckkontakte insbesondere in die Durchgangsöffnung 9 hineinragen. Der Steckkontakt dient zur elektrischen Kontaktierung mit anderen Modulen des Gerätes des Systems und zur elektrischen Übertragung der Tastensignale. Zudem weist der Schaltungsträger 11 vorzugsweise an seiner Rückseite eine Schaltelektronik zur Signalverarbeitung auf.

Auf der dem Modulunterteil 5 abgewandten und den Tasten 3 zugewandten Vorderseite des Schaltungsträgers 11 sind mindestens ein kapazitives MOC-Tastfeld 13 pro Taste 3, vorzugsweise zwei MOC-Tastfelder 13 pro Taste 3 angeordnet. Dabei steht "MOC" für "metal over cap" Technologie. Die Schaltwege derartiger MOC-Tastfelder 13 liegen in der Größenordnung von einigen Mikrometern (zum Beispiel 5 µm bis 10 µm). Die MOC-Tastfelder 13 sind als flächige Schaltsensoren auf dem Schaltungsträger 11 ausgebildet. Die MOC-Tastfelder 13 sind in Druckrichtung Z unterhalb der Taste 3 auf dem Schaltungsträger 11 angeordnet. Vorzugsweise sind pro Taste 3 zwei über die Längsrichtung L der Taste 3 voneinander beabstandete MOC-Tastfelder 13 angeordnet.

Über den MOC-Tastfeldern 13 des Schaltungsträgers 11 ist ein Tastenträger 19 zur Aufnahme der Bedienelemente 4 der Tasten 3 angeordnet und vorzugsweise mit dem Schaltungsträger 11 oder dem Modulunterteil 5 über nicht dargestellte Befestigungsmittel kraft- und/oder formschlüssig verbunden. Der Tastenträger 19 ist insbesondere in die Aufnahmeöffnung des Modulunterteils 5 eingesetzt und verschließt das Modulunterteil 5 zumindest teilweise.

Die Bedienelemente 4 weisen vorzugsweise einen Tastenrahmen 21 und ein in dem Tastenrahmen 21 angeordnetes Fensterelement 23 auf. Das Fensterelement 23 schließt bündig mit der Oberfläche des Tastenrahmens 21 ab, so dass beide zusammen eine Betätigungsfläche der Taste 3 bilden. Dabei bildet vorzugsweise das Fensterelement 23 zusammen mit dem Tastenträger 19 zwischen Fensterelement 23 und Tastenträger 19 einen Aufnahmeraum zur Aufnahme eines Beschriftungsschildes 25. Das Fensterelement 23 ist aus einem lichtdurchlässigen Material ausgebildet.

In dem Tastenträger 19 sind pro Taste 3 eine Aufnahmeöffnung ausgebildet, in der ein Druckübertragungselement 27 zumindest in Druckrichtung Z beweglich gelagert angeordnet ist. Das Druckübertragungselement 27 ist insbesondere mittels einer mit dem Tastenträger 19 und dem Druckübertragungselement 27 stoffschlüssig verbundenen Weichkomponente 26 in der jeweiligen Aufnahmeöffnung schwimmend gelagert. Die Weichkomponente 26 ist insbesondere aus einem elastischen, vorzugsweise gummiartigen, Material ausgebildet. Vorteilhafterweise ist die Weichkomponente 26 als eine das Druckübertragungselement 27 vollständig umlaufende und in einem durch die Aufnahmeöffnung gebildeten Spalt 31 zwischen Druckübertragungselement 27 und Tastenträger 19 angeordnete Dichtung ausgebildet. Dabei dient die Weichkomponente 26 einerseits als Lagerung der Druckübertragungselemente 27 in dem Tastenträger 19 und andererseits als Abdichtung des Tastenmoduls 1 vor einem Eintreten von Schmutz und Feuchtigkeit in das Tastenmodul 1 und insbesondere in den Aufnahmeraum des Modulunterteils 5. Insbesondere ist die Weichkomponente 26 auch zwischen dem Tastenträger 19 und dem Bedienelement 4 ausgebildet und formiert insbesondere eine elastische Auflagefläche für die Bedienelemente 4 der Tasten und insbesondere für den Tastenrahmen 21 auf dem Tastenträger 19.

Das Druckübertragungselement 27 ist vorzugsweise aus einem lichtdurchlässigen und/oder lichtleitenden Material ausgebildet. Der Tastenträger 19, die Druckübertragungselemente 27 und die Weichkomponente 26 sind vorzugsweise als ein Drei-Komponenten-Teil hergestellt.

In der dargestellten Ausführungsform weist der Tastenträger 19 vier Aufnahmeöffnungen auf, in denen jeweils ein Druckübertragungselement 27 angeordnet ist.

Durch eine von der Weichkomponente 26 gebildete elastische Auflagefläche auf den Flächen des Tastenträgers 19 werden ein Betätigungsweg und eine Betätigungskraft in Druckrichtung Z der Bedienelemente 4, die zum Auslösen eines Tastvorgangs erforderlich sind, auf gewünschte Größen eingestellt. Zudem beeinflusst die Materialbeschaffenheit und Materialdicke der Sensorfolie 15 der MOC-Tastfelder 13 die Betätigungskraft. Vorzugsweise sind die Weichkomponente 26 und die Sensorfolie 15 derart ausgebildet, dass die Betätigungskraft des Bedienelementes 4 einem Wert von 2,5 N bis 5 N entspricht. Die Weichkomponente 26 ist vorzugsweise im Bereich der elastischen Auflagefläche des Bedienelementes 4 gleichmäßig auf dem Tastenträger 19 verteilt. Dies ermöglicht in Kombination mit den MOC-Tastfeldern 13 insbesondere eine besonders homogene und über die kompletten Flächen der Bedienelemente 4 verteilte Betätigungskraft. Zudem bildet die Weichkomponente 26 zwischen Bedienelement 4 und Tastenträger 19 eine weitere Dichtung des Tastenmoduls 1.

In einer vorteilhaften Ausführungsform bildet die Weichkomponente 26 auf der dem Bedienelement 4 zugewandten Seite des Druckübertragungselementes 27 eine im Randbereich des Druckübertragungselementes 27 umlaufende Dichtlippe 30. Die Dichtlippe 30 dient insbesondere zur Abdichtung des Fensterelementes 23 des Bedienelementes 4, so dass das Beschriftungsfeld 25 vor Feuchtigkeit geschützt ist.

Die Druckübertragungselemente 27 sind insbesondere jeweils mit Befestigungsmitteln, insbesondere mit Schrauben 28, mit dem jeweilig zugeordneten Bedienelement 4, insbesondere mit dem Tastenrahmen 21, verbunden. Die Druckübertragungselemente 27 und der Tastenträger 19 sind vorzugsweise derart ausgebildet, dass die Druckübertragungselemente 27 in einer Ausgangsstellung der Tasten 3 ohne eine äußere Krafteinwirkung auf die Tasten 3 spielfrei auf den MOC-Tastfeldern 13 unmittelbar anliegen. Vorzugsweise weisen die Druckübertragungselemente 27 an ihrer den MOC-Tastfeldern 13 zugewandten Seite im Bereich über den zugeordneten MOC-Tastfeldern 13 dazu angeformte Druckdome 33 auf. Vorteilhafterweise sind die Druckdome 33 bezogen auf ihre Auflagefläche an die Fläche der MOC-Tastfelder 13 angepasst, so dass sie die MOC-Tastfelder 13 optimal auslösen können.

In einer weiteren Ausgestaltung der Erfindung ist eine Rückstellbewegung der Tasten 3 entgegengesetzt zur Druckrichtung Z begrenzt. Dazu ist an der dem Schaltungsträger 11 zugewandten Seite der Druckübertragungselemente 27 jeweils mindestens ein Begrenzungselement 29 angeordnet. Das Begrenzungselement 29 ist mit den Druckübertragungselementen 27 verbunden und bildet einen Anschlag gegen den Rand der Aufnahmeöffnung des Tastenträgers 19 für die Rückstellbewegung. Dies verhindert ein Abziehen der Bedienelemente 4 von dem Tastenträger 19 beziehungsweise entlastet die Lagerung der Druckübertragungselemente 27 in dem Tastenträger 19.

Vorzugsweise sind die Begrenzungselemente 29 plattenförmig, insbesondere als eine Art Unterlegscheibe einer Schraube ausgebildet. Insbesondere sind die Begrenzungselemente 29 über die gleichen Befestigungsmittel, über die die Druckübertragungselemente 27 mit den Bedienelementen 4, insbesondere dem Tastenrahmen 21, verbunden sind, mit den Druckübertragungselementen 27 verbunden.

In einer bevorzugten Ausgestaltung sind die Begrenzungsmittel 29, die Bedienelemente 4, der Tastenträger 19 und die Weichkomponente 26 derart bezogen auf ihre Bauhöhe in Druckrichtung Z ausgebildet, dass die Befestigungsmittel mittels der Begrenzungsmittel 29 die Bedienelemente 4 gegen den Tastenträger 19 ziehen und somit eine Vorspannung gegen die Weichkomponente 26 erzeugen. Dafür ist insbesondere die in Druckrichtung Z ausgebildete Bauhöhe des Druckübertragungselementes 27 kleiner/gleich die Bauhöhe des Tastenträgers 19 zusammen mit der Weichkomponente 26 gemessen von der Auflagefläche des Begrenzungselementes 29 bis zur Auflagefläche des Bedienelementes 4. Die Weichkomponente 26 ermöglicht auch einen Toleranzausgleich für insbesondere in Druckrichtung Z ausgebildete Toleranzen der einzelnen Bauteile bezogen auf die Bauhöhe.

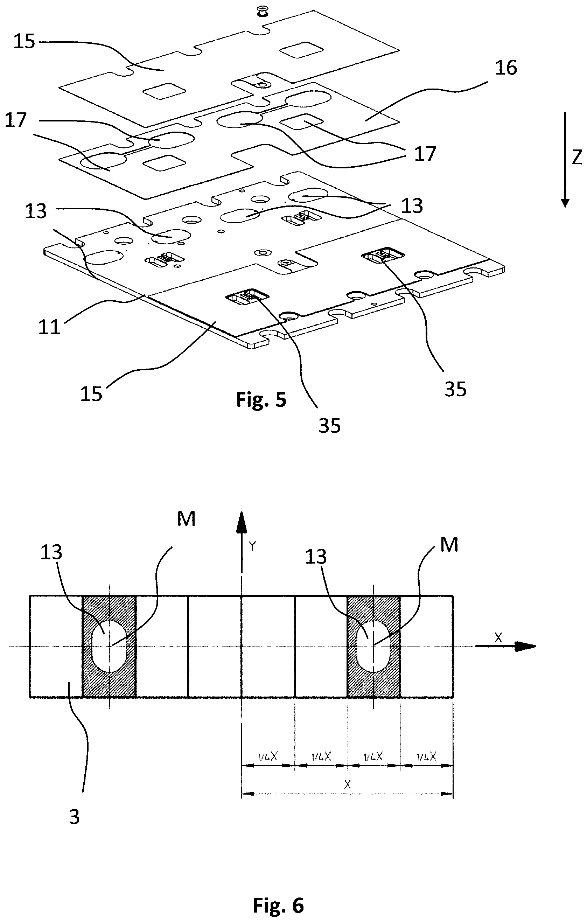

Figur 5 zeigt eine dreidimensionale Ansicht des Schaltungsträgers 11 als Explosionszeichnung einer Hälfte der Vorderseite des Schaltungsträgers 11. Bei MOC-Tastfeldern 13 handelt es sich um kapazitive Sensoren, die auf einer Trägerschicht, insbesondere dem Schaltungsträger 11, angeordnet sind. Beabstandet zu den kapazitiven Sensoren ist je eine elektrisch leitfähige Sensorfolie 15 (in der Regel eine metallische Schicht) vorgesehen. Eine Verformung dieser leitfähigen Sensorfolie 15 ruft eine Änderung des die Sensorfolie 15 umgebenden elektromagnetischen Feldes hervor, die vom kapazitiven Sensor erfasst wird. Um die Verformung der Sensorfolie 15 zu ermöglichen, ist zwischen dem Schaltungsträger 11 und der Sensorfolie 15 eine Abstandsfolie 16 angeordnet, die im Bereich der Taststellen 13 jeweils eine Aussparung 17 aufweist. Ein Vorteil derartiger MOC-Tastfelder 13 gegenüber herkömmlichen kapazitiven Sensoren ist die taktile, ortsgenaue Erfassung des Schaltsignals, sowie ihre geringe Einbaugröße. Vorteilhafterweise sind jeweils vier MOC-Tastfelder 13 von jeweils unterschiedlichen Tasten 3 einer gemeinsamen Sensorfolie 15 und insbesondere einer gemeinsamen Abstandsfolie 16 zugeordnet.

Vorteilhafterweise ist auf der den Tasten 3 zugewandten Seite des Schaltungsträgers 11 mindestens eine LED 35 ausgebildet. Dabei ist die LED 35 insbesondere in einer Aussparung der Sensorfolie 15 der MOC-Tastfelder 13 angeordnet. Die LED 35 ist vorteilhafterweise derart unter dem Moduloberteil 6 angeordnet, dass ihr Licht in das Druckübertragungselement 27 eingeleitet wird und dieses beleuchtet. Vorzugsweise weisen der Tastenträger 19 und/oder das Druckübertragungselement 27 auf der der LED 35 zugewandten Seite eine Einstrahlöffnung auf, in die die LED 35 hineinragt und/oder einstrahlt. Insbesondere sind in dem Tastenträger 19 und/oder dem Druckübertragungselement 27 Lichtleitmittel ausgebildet, die das Licht der LED 35 in dem Druckübertragungselement 27 verteilen und ein in dem Bedienelement 4 angeordnetes Beschriftungsschild 25, insbesondere als Hintergrundbeleuchtung, beleuchten. Vorzugsweise sind die LEDs 35 genau zwischen zwei Druckübertragungselementen 27 angeordnet, so dass eine LED 35 zwei Druckübertragungselemente 27 gleichzeitig beleuchten kann.

Vorteilhafterweise ist zwischen dem Druckübertragungselement 27 und dem Schaltungsträger 11 eine Reflexionsfolie 18 angeordnet. Die Reflexionsfolie 18 ermöglicht eine verbesserte Homogenität und Helligkeit der Beleuchtung des Druckübertragungselementes 27.

Figur 6 zeigt eine bevorzugte Anordnung der MOC-Tastfelder 13 auf dem Schaltungsträger 11 unter einer zugeordneten Taste 3. Dabei hat sich für eine homogene Verteilung der erforderlichen Betätigungskraft auf die Taste 3 als besonders vorteilhaft erwiesen, wenn pro Taste 3 genau zwei MOC-Tastfelder 13 bezogen auf eine Mittelsenkrechte Y der Taste 3 spiegelsymmetrisch zueinander und in Längsrichtung L der Taste 3 voneinander beabstandet angeordnet sind. Vorzugsweise beträgt der Abstand des Mittelpunktes M der beiden MOC-Tastfelder 13 von der Mittelsenkrechten Y mindestens 0,5 X und höchstens 0,75 X, wobei X die halbe Länge der Taste 3 in Längsrichtung L ist. Insbesondere ist der Mittelpunkt M der MOC-Tastfelder 13 bezogen auf die Querrichtung der Taste 3 mittig unter der Taste 3 angeordnet.

### Bezugszeichenliste

- 1: Tastenmodul
- 3: Tasten
- 4: Bedienelemente
- 5: Modulunterteil
- 6: Moduloberteil
- 9: Durchgangsöffnung
- 11: Schaltungsträger
- 13: MOC-Tastfeld
- 15: Sensorfolie
- 16: Abstandsfolie
- 17: Aussparung
- 18: Reflexionsfolie
- 19: Tastenträger
- 21: Tastenrahmen
- 23: Fensterelement
- 25: Beschriftungsfeld
- 26: Weichkomponente
- 27: Druckübertragungselement
- 28: Schrauben
- 29: Begrenzungselement
- 30: Dichtlippe
- 31: Spalt
- 33: Druckdom
- 35: LED

- Y: Mittelsenkrechte
- L: Längsrichtung
- Z: Druckrichtung
- G: Grundrissebene
- M: Mittelpunkt

## Patentansprüche

1. Tastenmodul (1) für modulare Systemgeräte der Gebäudeelektroinstallation oder Haustürkommunikation, aufweisend mindestens eine durch Druck in eine Druckrichtung (Z) senkrecht zu einer Grundrissebene (G) betätigbare Taste (3), und ein in Druckrichtung (Z) in einen Systemträger eines Systemgerätes montierbares Modulunterteil (5), und ein durch Montage in der Druckrichtung (Z) mit dem Modulunterteil (5) verbundenes Moduloberteil (6), wobei das Moduloberteil (6) einen Tastenträger (19) umfasst, an dem die Taste (3) in Druckrichtung (Z) beweglich gelagert angeordnet ist, und wobei in dem Modulunterteil (5) ein Schaltungsträger (11) mit einer elektronischen Schaltung aufgenommen ist, welche Schaltsensoren enthält, mittels derer unter der Wirkung des in der Druckrichtung (Z) auf die Taste (3) ausgeübten Druckes ein Schaltvorgang ausgelöst wird,
**dadurch gekennzeichnet, dass**
die Schaltsensoren des Schaltungsträgers (11) als MOC-Tastfeld (13) ausgebildet sind, und in einer Aufnahmeöffnung des Tastenträgers (19) mindestens ein Druckübertragungselement (27) pro Taste (3) zur Betätigung des MOC-Tastfeldes (13) in Druckrichtung (Z) über mindestens ein MOC-Tastfeld (13) bewegbar gelagert angeordnet ist, und die Taste (3) mit dem Druckübertragungselement (27) verbunden ist,
wobei eine Weichkomponente (26) aus einem elastischen Material stoffschlüssig mit dem Druckübertragungselement (27) und dem Tastenträger (19) verbunden ist und das Druckübertragungselement (27) mittels der Weichkomponente (26) in der Aufnahmeöffnung des Tastenträgers (19) schwimmend gelagert ist,
wobei das Druckübertragungselement (27), die Weichkomponente (26) und der Tastenträger (19) als Drei-Komponenten-Teil einteilig ausgebildet sind,
wobei eine Weichkomponente (26) aus elastischem Material zwischen Taste (3) und Tastenträger (19) angeordnet ist, wobei die Taste (3) mittels Befestigungsmitteln (28) und einem Begrenzungselement (29) an der der Taste abgewandten Seite des Tastenträgers (19) mit einer Vorspannung auf die Weichkomponente (26) in Richtung des Tastenträgers (19) gezogen wird.

2. Tastenmodul (1) nach Anspruch 1,
**dadurch gekennzeichnet, dass**
das Druckübertragungselement (27) in Druckrichtung (Z) über mindestens zwei in einer Längsrichtung (L) der Taste (3) nebeneinander angeordneten MOC-Tastfeldern (13) angeordnet ist.

3. Tastenmodul (1) nach Anspruch 1 oder 2,
**dadurch gekennzeichnet, dass**
die Weichkomponente (26) als eine die Druckübertragungselemente (27) vollständig umlaufende und in einem durch die Aufnahmeöffnung gebildeten Spalt (31) zwischen Druckübertragungselement (27) und Tastenträger (19) angeordnete Dichtung ausgebildet ist.

4. Tastenmodul (1) nach einem der Ansprüche 1 bis 3,
**dadurch gekennzeichnet, dass**
das Druckübertragungselement (27) aus einem lichtdurchlässigen und/oder lichtleitenden Material ausgebildet ist.

5. Tastenmodul (1) nach einem der Ansprüche 1 bis 4,
**dadurch gekennzeichnet, dass**
die Taste (3) durch Anlage auf der Weichkomponente (26) an der der Taste (3) zugewandten Seite des Tastenträgers (19) und gleichzeitigen Anlage des Begrenzungselementes (29) an der der Taste (3) abgewandten Seite des Tastenträgers (19) spielfrei gelagert ist.

6. Tastenmodul (1) nach einem der Ansprüche 1 bis 5,
**dadurch gekennzeichnet, dass**
das Druckübertragungselement (27) in Druckrichtung (Z) unmittelbar anliegend an das MOC-Tastfeld (13) oder die MOC-Tastfelder (13) angeordnet ist.

7. Tastenmodul (1) nach einem der Ansprüche 1 bis 6,
**dadurch gekennzeichnet, dass**
die Taste (3) in Druckrichtung (Z) unmittelbar anliegend an das Druckübertragungselement (27) angeordnet ist.

8. Tastenmodul (1) nach einem der Ansprüche 1 bis 7,
**dadurch gekennzeichnet, dass**
der Schaltungsträger (11) mindestens eine LED (35) aufweist, die derart unter dem Moduloberteil (6) angeordnet ist, dass ihr Licht in das Druckübertragungselement (27) eingeleitet wird und dieses beleuchtet.

9. Tastenmodul (1) nach Anspruch 8,
**dadurch gekennzeichnet, dass**
der Tastenträger (19) und/oder das Druckübertragungselement (27) auf der der LED (35) zugewandten Seite Einstrahlöffnungen aufweisen, in die die LED (35) hineinragt und/oder einstrahlt.

10. Tastenmodul (1) nach einem der Ansprüche 1 bis 9,
**dadurch gekennzeichnet, dass**
pro Taste (3) genau zwei MOC-Tastfelder (13) bezogen auf eine Mittelsenkrechte (Y) der Taste (3) spiegelsymmetrisch zueinander und in Längsrichtung (L) der Taste (3) voneinander beabstandet angeordnet sind.

11. Tastenmodul (1) nach Anspruch 10,
**dadurch gekennzeichnet, dass**
der Abstand eines Mittelpunktes (M) der beiden MOC-Tastfelder (13) von der Mittelsenkrechten (Y) mindestens 0,5 X und höchstens 0,75 X beträgt, wobei X die halbe Länge der Taste (3) in Längsrichtung (L) ist.

12. Tastenmodul (1) nach einem der Ansprüche 1 bis 11,
**dadurch gekennzeichnet, dass**
die Weichkomponente (26) auf der dem Bedienelement (4) zugewandten Seite des Druckübertragungselementes (27) eine im Randbereich des Druckübertragungselementes (27) angeordnete umlaufende Dichtlippe (30) bildet.

13. Tastenmodul (1) nach einem der Ansprüche 1 bis 12,
**dadurch gekennzeichnet, dass**
das Druckübertragungselement (27) an seiner den MOC-Tastfeldern (13) zugewandten Seite im Bereich über den zugeordneten MOC-Tastfeldern (13) angeformte Druckdome (33) aufweist.

14. Tastenmodul (1) nach einem der Ansprüche 1 bis 13,
**dadurch gekennzeichnet, dass**
zwischen dem Druckübertragungselement (27) und dem Schaltungsträger (11) eine Reflexionsfolie (18) angeordnet ist.

## Claims

1. Key module (1) for modular system devices for electrical installation in buildings or domestic door communication, having at least one key (3) which can be operated by being pressed in a pressing direction (Z) perpendicularly in relation to a layout plane (G), and a module lower part (5) which can be mounted into a system carrier of a system device in the pressing direction (Z), and a module upper part (6) which is connected to the module lower part (5) by mounting in the pressing direction (Z), wherein the module upper part (6) comprises a key carrier (19) on which the key (3) is arranged in a manner mounted such that it can move in the pressing direction (Z), and wherein a circuit carrier (11) with an electronic circuit is accommodated in the module lower part (5), which electronic circuit contains switching sensors by means of which a switching process is triggered under the action of the pressure which is exerted onto the key (3) in the pressing direction (Z),
**characterized in that** the switching sensors of the circuit carrier (11) are designed as MOC touch pads (13), and at least one pressure-transmitting element (27) for each key (3) is arranged in a receiving opening of the key carrier (19) in a manner mounted such that it can move over at least one MOC touch pad (13) for operating the MOC touch pad (13) in the pressing direction (Z), and the key (3) is connected to the pressure-transmitting element (27),
wherein a soft component (26) composed of an elastic material is connected in a materially bonded manner to the pressure-transmitting element (27) and to the key carrier (19) and the pressure-transmitting element (27) is mounted in a floating manner by means of the soft component (26) in the receiving opening of the key carrier (19),
wherein the pressure-transmitting element (27), the soft component (26) and the key carrier (19) are integrally formed as a three-component part, wherein a soft component (26) composed of elastic material is arranged between the key (3) and the key carrier (19), wherein the key (3) is pulled with a pretension on the soft component (26) in the direction of the key carrier (19) by means of fastening means (28) and a delimiting element (29) on that side of the key carrier (19) which is averted from the key.

2. Key module (1) according to Claim 1,
**characterized in that** the pressure-transmitting element (27) is arranged in the pressing direction (Z) over at least two MOC touch pads (13) which are arranged next to one another in a longitudinal direction (L) of the key (3).

3. Key module (1) according to Claim 1 or 2,
**characterized in that** the soft component (26) is designed as a seal which completely encircles the pressure-transmitting elements (27) and is arranged in a gap (31) between the pressure-transmitting element (27) and the key carrier (19), which gap is formed by the receiving opening.

4. Key module (1) according to one of Claims 1 to 3,
**characterized in that** the pressure-transmitting element (27) is formed from a transparent and/or light-guiding material.

5. Key module (1) according to one of Claims 1 to 4,
**characterized in that** the key (3) is mounted without play by being supported on the soft component (26) on that side of the key support (19) which faces the key (3) and at the same time the delimiting element (29) by being supported on that side of the key support (19) which is averted from the key (3).

6. Key module (1) according to one of Claims 1 to 5,
**characterized in that** the pressure-transmitting element (27) is arranged in a manner bearing directly against the MOC touch pad (13) or the MOC touch pads (13) in the pressing direction (Z).

7. Key module (1) according to one of Claims 1 to 6,
**characterized in that** the key (3) is arranged in a manner bearing directly against the pressure-transmitting element (27) in the pressing direction (Z).

8. Key module (1) according to one of Claims 1 to 7,
**characterized in that** the circuit carrier (11) has at least one LED (35) which is arranged beneath the module upper part (6) in such a way that its light is introduced into the pressure-transmitting element (27) and illuminates it.

9. Key module (1) according to Claim 8,
**characterized in that** the key carrier (19) and/or the pressure-transmitting element (27) have irradiation openings on that side which faces the LED (35), the LED (35) protruding and/or shining into the said irradiation openings.

10. Key module (1) according to one of Claims 1 to 9,
**characterized in that** for each key (3) precisely two MOC touch pads (13) are arranged with mirror-image symmetry in relation to one another with respect to a centre perpendicular (Y) of the key (3) and at a distance from one another in the longitudinal direction (L) of the key (3).

11. Key module (1) according to Claim 10,
**characterized in that** the distance of a centre point (M) of the two MOC touch pads (13) from the centre perpendicular (Y) is at least 0.5 X and at most 0.75 X, wherein X is half the length of the key (3) in the longitudinal direction (L).

12. Key module (1) according to one of Claims 1 to 11,
**characterized in that** the soft component (26) forms an encircling sealing lip (30), which is arranged in the edge region of the pressure-transmitting element (27), on that side of the pressure-transmitting element (27) which faces the operator control element (4).

13. Key module (1) according to one of Claims 1 to 12,
**characterized in that** the pressure-transmitting element (27) has pressing domes (33) which are integrally formed on its side which faces the MOC touch pads (13) in the region above the associated MOC touch pads (13).

14. Key module (1) according to one of Claims 1 to 13,
**characterized in that** a reflection film (18) is arranged between the pressure-transmitting element (27) and the circuit carrier (11).

## Revendications

1. Module de touches (1) destiné à des appareils de systèmes modulaires d'une installation électrique de bâtiment ou de communication de porte d'entrée, comprenant au moins une touche (3) pouvant être actionnée par pression dans une direction de pression (Z) perpendiculaire à un plan d'ensemble (G) et une partie inférieure de module (5) qui peut être montée dans la direction de pression (Z) dans un support de système d'un appareil de système, et une partie supérieure de module (6) reliée par montage dans la direction de pression (Z) à la partie inférieure de module (5), dans lequel la partie supérieure de module (6) comprend un support de touche (19) sur lequel la touche (3) est montée de manière mobile dans la direction de pression (Z), et dans lequel la partie inférieure de module (5) reçoit un support de circuit (11) comportant un circuit électronique qui contient des capteurs de commutation au moyen desquels une opération de commutation est déclenchée sous l'effet de la pression exercée sur la touche (3) dans la direction de pression (Z),
**caractérisé en ce que** les capteurs de commutation du support de circuit (11) sont réalisés sous la forme d'un champ de touche MOC (13), et au moins un élément de transmission de pression (27) par touche (3) est monté mobile au-dessus d'au moins un champ de touche MOC (13) dans une ouverture de réception du support de touche (19) pour actionner le champ de touche MOC (13) dans la direction de pression (Z) et la touche (3) est reliée à l'élément de transmission de pression (27),
dans lequel un composant souple (26) constitué d'un matériau élastique est relié par complémentarité de matériau à l'élément de transmission de pression (27) et au support de touche (19) et l'élément de transmission de pression (27) est monté flottant au moyen du composant souple (26) dans l'ouverture de réception du support de touche (19),
dans lequel l'élément de transmission de pression (27), le composant souple (26) et le support de touche (19) sont réalisés d'un seul tenant sous la forme d'une pièce à trois composants,
dans lequel un composant souple (26) constitué de matériau élastique est disposé entre la touche (3) et le support de touche (19), dans lequel la touche (3) est tirée dans la direction du support de touche (19) à l'aide d'une précharge s'exerçant sur le composant souple (26) à l'aide de moyens de fixation (28) et d'un élément de limitation (29) sur la face du support de touche (19) qui est tournée à l'opposé de la touche.

2. Module de touches (1) selon la revendication 1,
**caractérisé en ce que** l'élément de transmission de pression (27) est disposé dans la direction de pression (Z) au-dessus d'au moins deux champs de touches MOC (13) disposés côte à côte dans une direction longitudinale (L) de la touche (3).

3. Module de touches (1) selon la revendication 1 ou 2,
**caractérisé en ce que** le composant souple (26) est réalisé sous la forme d'un joint qui entoure entièrement les éléments de transmission de pression (27) et est disposé dans un espace (31) formé par l'ouverture de réception entre l'élément de transmission de pression (27) et le support de touches (19).

4. Module de touches (1) selon l'une des revendications 1 à 3,
**caractérisé en ce que** l'élément de transmission de pression (27) est constitué d'un matériau translucide et/ou conducteur de la lumière.

5. Module de touches (1) selon l'une des revendications 1 à 4,
**caractérisé en ce que** la touche (3) est montée sans jeu en reposant sur le composant souple (26) sur la face du support de touche (19) qui est tournée vers la touche (3) et en faisant en sorte que l'élément de limitation (29) repose simultanément sur la face du support de touche (19) qui est opposée à la touche (3).

6. Module de touches (1) selon l'une des revendications 1 à 5,
**caractérisé en ce que** l'élément de transmission de pression (27) est disposé de manière directement adjacente au champ de touche MOC (13) ou aux champs de touches MOC (13) dans la direction de pression (Z).

7. Module de touches (1) selon l'une des revendications 1 à 6,
**caractérisé en ce que** la touche (3) est disposée de manière directement adjacente à l'élément de transmission de pression (27) dans la direction de pression (Z).

8. Module de touches (1) selon l'une des revendications 1 à 7,
**caractérisé en ce que** le support de circuit (11) comporte au moins une LED (35) qui est disposée sous la partie supérieure de module (6) de manière à ce que sa lumière soit introduite dans l'élément de transmission de pression (27) et éclaire ce dernier.

9. Module de touches (1) selon la revendication 8,
**caractérisé en ce que** le support de touche (19) et/ou l'élément de transmission de pression (27) présentent, sur la face qui est tournée vers la LED (35), des ouvertures d'injection de rayonnement dans lesquelles la LED (35) dépasse et/ou injecte un rayonnement.

10. Module de touches (1) selon l'une des revendications 1 à 9,
**caractérisé en ce qu'**exactement deux champs de touches MOC (13) par touche (3) sont disposés symétriquement par réflexion l'un par rapport à l'autre et sont espacés l'un de l'autre dans la direction longitudinale (L) de la touche (3) par rapport à une droite perpendiculaire centrale (Y) de la touche (3).

11. Module de touches (1) selon la revendication 10,
**caractérisé en ce que** la distance d'un point central (M) des deux champs de touches MOC (13) par rapport à la droite perpendiculaire centrale (Y) est d'au moins 0,5 X et d'au plus 0,75 X, dans lequel X est égal à la moitié de la longueur de la touche (3) dans la direction longitudinale (L).

12. Module de touches (1) selon l'une des revendications 1 à 11,
**caractérisé en ce que** le composant souple (26) forme sur la face de l'élément de transmission de pression (27) qui est tournée vers l'élément de commande (4) un rebord d'étanchéité (30) périphérique disposé dans la zone de bord de l'élément de transmission de pression (27).

13. Module de touches (1) selon l'une des revendications 1 à 12,
**caractérisé en ce que** l'élément de transmission de pression (27) présente sur sa face qui est tournée vers les champs de touches MOC (13) des dômes de pression (33) formés dans la zone située au-dessus des champs de touches MOC (13) associés.

14. Module de touches (1) selon l'une des revendications 1 à 13,
**caractérisé en ce qu'**une feuille réfléchissante (18) est disposée entre l'élément de transmission de pression (27) et le support de circuit (11).
